# EUROPÄISCHE PATENTSCHRIFT

(11) **EP 3 884 240 B1**
(45) Veröffentlichungstag und Bekanntmachung des Hinweises auf die Patenterteilung: **03.07.2024**
(21) Anmeldenummer: 19809049.0
(22) Anmeldetag: 22.11.2019
(51) Int. Cl.: G01D 5/20, G01P 3/488

(54) **MAGNETISCHES POSITIONSSENSORSYSTEM UND SENSORMODUL**
MAGNETIC POSITION SENSOR SYSTEM AND SENSOR MODULE
SYSTÈME DE CAPTEUR DE POSITIONNEMENT MAGNÉTIQUE ET MODULE DE CAPTEUR

(30) Priorität: 22.11.2018 DE 102018220032
(43) Veröffentlichungstag der Anmeldung: 29.09.2021
(73) Patentinhaber: Vitesco Technologies Germany GmbH, 93055 Regensburg (DE)
(72) Erfinder: REUNING, Felix, 81737 München (DE); ACKER, Heinrich, 81737 München (DE); KIESS, Alex, 81737 München (DE); REBELEIN, Andreas, 81737 München (DE); SCHUCH, Bernhard, 81737 München (DE)
(74) Vertreter: Vitesco Technologies
(86) Internationale Anmeldenummer: PCT/EP2019/082230
(87) Internationale Veröffentlichungsnummer: WO 2020/104656

(56) Entgegenhaltungen:
- WO-A1-2015/028002
- DE-A1-102017 109 114
- JP-A- 2001 201 363
- US-A1- 2013 057 267
- US-B1- 6 605 939

## Beschreibung

Die Erfindung betrifft ein magnetisches Positionssensorsystem und ein Sensormodul mit einem derartigen Positionssensorsystem.

Positions- oder Abstandssensoren werden zum Beispiel eingesetzt, um Gangstellerbewegungen in Kraftfahrzeuggetrieben berührungslos zu überwachen. Ein magnetischer Positionssensor ist beispielsweise aus der DE 10 2006 061 771 A1, der EP 2 149 784 B1, der US 6 605 939 B1, der JP 2001 201363 A und der WO 2015/028002 A1 bekannt.

Aus der DE 10 2017 109 114 A1 ist zudem ein Kraftsensor bekannt zum unmittelbaren Messen von axialen Kräften in einem zumindest teilweise aus magnetostriktiven oder magnetoelastischen Material gebildeten Lastelement. Der Kraftsensor umfasst wenigstens eine Generatorspule zum Erzeugen eines Magnetfelds in dem Lastelement und eine Magnetfelderfassungseinrichtung zum Erfassen eines Magnetfelds in dem Lastelement. Die Generatorspule ist derart um das Lastelement herum anzuordnen, dass das Lastelement als Spulenkern für die Generatorspule wirkt, und die Magnetfelderfassungseinrichtung ist ebenfalls um das Lastelement herum angeordnet.

Aus der US 2013/057267 A1 ist ein Stromsensor bekannt, der eine gedruckte Schaltung und elektrische Leitungen umfasst. Die gedruckte Schaltung besteht aus einem in vertikaler Richtung verlaufenden Stapel von Metallisierungsschichten, die durch elektrisch isolierende Schichten voneinander getrennt sind, und einer Mess- oder Erregerspule, die um eine vertikale Wickelachse gewickelt ist. Die Spule besteht aus Windungen, die durch Leiterbahnen in den jeweiligen Metallisierungsschichten gebildet werden, die durch Kontaktstellen, die durch mindestens eine der elektrisch isolierenden Schichten verlaufen, elektrisch miteinander verbunden sind, um eine Spule zu bilden, die sich entlang der vertikalen Wickelachse erstreckt.

Eine mögliche Ausführung eines solchen Sensorsystems ist der sogenannte Permanentmagnetic Linear Contactless Displacement Sensor, kurz PLCD-Sensor.

Bei einem konventionellen PLCD-Sensorsystem wird insbesondere für das Erfassen der Position zum Beispiel eines Magneten, ein von Spulen umwickelter weichmagnetischer Kern auf einer Leiterplatte aufgebracht.

Für die Auswertung des Sensorsystems ist insbesondere noch eine entsprechende integrierte Schaltung mit zusätzlicher Außenbeschaltung erforderlich.

Dafür ist in der Regel ein relativ großer Einbauraum notwendig. Die entsprechende Aufbautechnik ist aufwändig und kostenintensiv. Zudem sind meist extra Schutzmaßnahmen wie ein Verguss oder eine extra Beschichtung des Systems gegen Umwelteinflüsse notwendig.

Es ist daher eine Aufgabe der vorliegenden Erfindung, ein magnetisches Positionssensorsystem anzugeben, das kompakt, zuverlässig und einfach und kostengünstig herzustellen ist.

Diese Aufgabe ist erfindungsgemäß durch ein Sensorsystem mit den im Anspruch 1 genannten Merkmalen gelöst.

Das magnetische Positionssensorsystem umfasst,
- eine Mehrlagenleiterplatte
- wobei eine Lage der Mehrlagenleiterplatte eine Isolatorschicht, insbesondere eine sogenannte Prepregschicht und mindestens eine Kupferschicht umfasst,
- eine Kupferschicht mindestens eine erste Leiterbahn und/ oder eine zweite Leiterbahn umfasst,
- erste Durchkontaktierungen, zweite Durchkontaktierungen und einen Leiterplattenkern, und
- einen Sensor mit einem weichmagnetischen Kern, einer Erregungsspule mit wenigstens einer Erregungswicklung und einer Sensorspule mit wenigstens einer Sensorwicklung.

Leiterplatten bestehen herkömmlich aus einer oder mehreren Substratlagen aus glasfaserverstärktem, ausgehärteten Epoxidharz, die zur Ausbildung von elektrisch leitenden Strukturen, insbesondere Leiterbahnen ein- oder beidseitig kupferkaschiert sind. Insbesondere bei mehrlagigen Leiterplatten werden eine oder mehrere dieser Substratlagen mittels Prepregs und teilweise auch zusätzlich mit Kupferfolien verpresst. Die Substratlagen und Prepregs bilden elektrisch isolierende Substratlagen der mehrlagigen Leiterplatte.

Die isolierten Leiterbahnen zwischen elektrisch isolierenden Substratlagen werden durch metallisierte Durchkontaktierungen in der Mehrlagenleiterplatte elektrisch miteinander verbunden.

Erfindungsgemäß ist der weichmagnetische Kern gänzlich im Leiterplattenkern der Mehrlagenleiterplatte angeordnet, und von einer Erregungsspule und einer Sensorspule umgeben ist, wobei eine Erregungswicklung der Erregungsspule je zwei erste Durchkontaktierungen, wenigstens abschnittsweise, und zwei erste Leiterbahnen umfasst, und wobei eine Sensorwicklung der Sensorspule je zwei zweite Durchkontaktierungen, zumindest Abschnitte davon, und zwei zweite Leiterbahnen umfasst. Der weichmagnetische Kern ist von der Erregungsspule mit mindestens einer Erregungswicklung und der Sensorspule mit mindestens einer Sensorwicklung im Wesentlichen konzentrisch umgeben.

Dabei wird vorteilhafterweise der weichmagnetische Kern direkt in die Leiterplatte eingebettet. Eine Spulenwicklung der Erregungsspule bzw. der Sensorspule um den Kern, wird dabei jeweils durch eine erste bzw. zweite Leiterbahn auf einer Kupferschicht, welche wiederum mit Hilfe von entsprechenden Abschnitten der ersten bzw. zweiten Durchkontaktierungen elektrisch verbunden sind, realisiert.

Das führt zu einer Reduzierung der sonst üblicherweise benötigten Bauraumhöhe. Das System ist durch dieses Aufbaukonzept resistenter gegen schädliche Umwelteinflüsse und durch die Minimierung der Produktionsprozesse werden die Herstellungskosten reduziert.

Bei einer Ausführungsform des Positionssensorsystem sind die Erregungsspule und die Sensorspule auf unterschiedlichen Lagen der Mehrlagenleiterplatte angeordnet.

Bei einer weiteren Ausführungsform des Positionssensorsystems sind die Erregungsspule und die Sensorspule auf derselben Lage der Mehrlagenleiterplatte angeordnet, wodurch die Anzahl der Lagen und damit die Bauhöhe des Positionssensorsystems je nach Anwendungsfall besonders klein gehalten werden kann.

Bei einer Weiterbildung des Positionssensorsystems umfasst eine Erregungswicklung je zwei erste Durchkontaktierungen und zwei erste Leiterbahnen auf der äußeren Kupferschicht, und eine Sensorwicklung umfasst je zwei zweite Durchkontaktierungen und zwei zweite Leiterbahnen auf der äußeren Kupferschicht.

Bei einer weiteren Ausführungsform des Positionssensorsystems sind die jeweiligen Längen der Mehrlagenleiterplatte, der Erregungsspule, der Sensorspule und des Kerns äußere und innere Abschnitte unterteilt.

Die Längen können innerhalb des Maximalwertes der Mehrlagenleiterplatte unterschiedliche Werte annehmen, das heißt insbesondere, dass sich die jeweiligen Längen der Erregungsspule und der Sensorspule unterscheiden können.

Bei Weiterbildungen des Positionssensorsystems können die Wicklungen der Erregungsspule und/ oder der Sensorspule gleichmäßig über die entsprechende Länge verteilt sein, wobei der Abstand der einzelnen Wicklungen insbesondere gleich ist. In manchen Fällen kann der Abstand der einzelnen Wicklungen über die entsprechende Länge auch variieren.

Bei einer weiteren Ausführungsform des Positionssensorsystems können die Wicklungen der Erregungsspule und/ oder der Sensorspule nicht gleichmäßig über die entsprechende Länge verteilt sein. Dabei können die Wicklungen der Erregungsspule und/ oder der Sensorspule vorwiegend an einem äußeren Abschnitt oder beiden äußeren Abschnitten angeordnet sein, wobei dann die äußeren Abschnitte kernseitig beispielsweise mit einem geraden Leiterstück miteinander elektrisch leitend verbunden sind. Es wäre auch denkbar, dass die Wicklungen der Erregungsspule und/ oder der Sensorspule vorwiegend im inneren Abschnitt, insbesondere im Bereich des weichmagnetischen Kerns, angeordnet sind.

Bei einer weiteren Ausführungsform des Positionssensorsystems schließt die Erregungsspule die Sensorspule abschnittsweise oder ganz ein, oder umgekehrt.

Insbesondere können je nach Anwendungsfall Erregungswicklungen einer Erregungsspule beziehungsweise Sensorwicklungen einer Sensorspule aus Leiterbahnen und Durchkontaktierungen, beziehungsweise entsprechenden Abschnitten der Durchkontaktierungen insbesondere in Bezug auf die Lagen der Mehrlagenleiterplatte und/ oder in Bezug auf die Durchkontaktierungen symmetrisch oder asymmetrisch zum weichmagnetischen Kern angeordnet sein.

Bei einer weiteren Ausführungsform des Positionssensorsystems ist der weichmagnetische Kern, insbesondere wie das gesamte Positionssensorsystem, streifenförmig ausgebildet, wobei insbesondere die Position eines, sich in einer Achse parallel zur Mehrlagenleiterplatte bewegenden Magnetes detektiert werden kann.

Eine weitere Aufgabe der vorliegenden Erfindung ist es, ein Sensormodul anzugeben, das kompakt, zuverlässig und einfach und kostengünstig herzustellen ist.

Diese Aufgabe ist erfindungsgemäß durch ein Sensormodul mit den im Anspruch 15 genannten Merkmalen gelöst.

Das Sensormodul umfasst wenigstens ein erfindungsgemäßes Positionssensorsystem und zumindest Teile einer Auswerteelektronik, wobei die Auswerteelektronik zumindest teilweise in der Mehrlagenleiterplatte angeordnet sein kann, was eine besonders kompakte und gesicherte Ausführungsform eines Sensormoduls darstellt.

Alternativ kann die Auswerteelektronik oder Teile davon, je nach Anforderung auch auf irgendeiner Außenfläche der Mehrlagenleiterplatte angeordnet sein.

Bei einer weiteren Ausführungsform kann die Auswerteelektronik zumindest teilweise außerhalb der Mehrlagenleiterplatte angeordnet sein.

In der nachfolgenden Beschreibung werden die Merkmale und Einzelheiten der Erfindung in Zusammenhang mit den beigefügten Zeichnungen anhand von Ausführungsbeispielen näher erläutert. In den Zeichnungen zeigen:
Fig. 1 eine schematische Darstellung eines Positionssensorsystems im Schnitt,
Fig. 2 eine schematische dreidimensionale Darstellung eines Positionssensorsystems gemäß Fig. 1, und
Fig. 3 eine schematische Darstellung eines Sensormoduls mit einem Positionssensorsystem gemäß Fig. 1.
Fig. 4 eine schematische Darstellung wie Fig. 1 mit zusätzlichen Lagen,
Fig. 5 bis 7 unterschiedliche schematische Darstellungen gemäß Fig. 4 im Längsschnitt

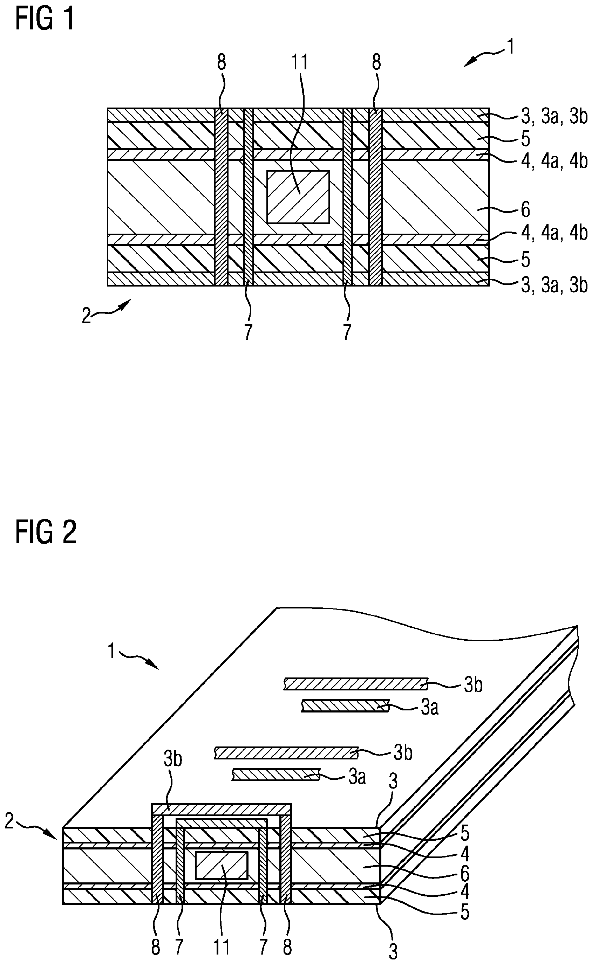

Fig. 1 zeigt eine schematische Darstellung eines magnetischen Positionssensorsystems 1 im Schnitt, wobei hier der Querschnitt rechteckig ist. Das magnetische Positionssensorsystem 1 umfasst eine Mehrlagenleiterplatte 2 mit je einer äußeren Kupferschicht 3 auf der Oberseite und der Unterseite der Mehrlagenleiterplatte 2 mit jeweils ersten äußeren Leiterbahnen 3a und zweiten äußeren Leiterbahnen 3b auf der entsprechenden äußeren Kupferschicht 3 an der Oberseite bzw. der Unterseite der Mehrlagenleiterplatte 2 . Weiterhin umfasst die Mehrlagenleiterplatte 2 in diesem Beispiel zwei Prepregschichten 5 als Isolatorschicht und zwei innere Kupferschichten 4, die einen Leiterplattenkern 6 einschließen. Dabei umfasst eine Kupferschicht 4 insbesondere jeweils erste innere Leiterbahnen 4a und zweite innere Leiterbahnen 4b.

Die Kupferschichten 3, 4, die äußeren Leiterbahnen 3a, 3b und die inneren Leiterbahnen 4a, 4b werden insbesondere durch erste und zweite Durchkontaktierungen 7, 8, oder durch entsprechende Abschnitte davon, miteinander elektrisch verbunden.

Weiterhin umfasst das magnetische Positionssensorsystem 1 einen Sensor mit einem weichmagnetischen Kern 11, der gänzlich im Leiterplattenkern 6 der Mehrlagenleiterplatte 2 angeordnet ist. Der Kern 11 ist von einer Erregungsspule mit mindestens einer Erregungswicklung und einer Sensorspule mit mindestens einer Sensorwicklung im Wesentlichen konzentrisch umgeben.

Eine Erregungswicklung umfasst in Fig. 1 eine erste äußere Leiterbahn 3a auf der äußeren Kupferschicht 3 der Oberseite und eine erste äußere Leiterbahn 3a auf der äußeren Kupferschicht 3 der Unterseite der Mehrlagenleiterplatte 2. Diese Leiterbahnen 3a werden je mit zwei ersten Durchkontaktierungen 7 zur Ausbildung der Erregungswicklung 3a, 7, 3a, 7 elektrisch miteinander verbunden. Diese Erregungswicklung 3a, 7, 3a, 7 ist in Fig. 1 dem Kern 11 am nächsten.

Eine Sensorwicklung umfasst eine zweite äußere Leiterbahn 3b auf der äußeren Kupferschicht 3 der Oberseite und eine zweite äußere Leiterbahn 3b auf der äußeren Kupferschicht 3 der Unterseite der Mehrlagenleiterplatte 2. Diese zweiten äußeren Leiterbahnen 3b werden je mit zwei zweiten Durchkontaktierungen 8 zur Ausbildung der Sensorwicklung 3b, 8, 3b, 8 elektrisch miteinander verbunden. Diese Sensorwicklung 3b, 8, 3b, 8 in Fig. 1 umschließt die Erregerwicklung mit dem Kern 11.

Alternativ kann die Erregerwicklung auch die Sensorwicklung einschließen.

Fig. 2 zeigt eine schematische dreidimensionale Darstellung eines Positionssensorsystems 1 gemäß Fig. 1. Die Mehrlagenleiterplatte 2 und der darin eingebettete Kern 11 sind streifenförmig ausgebildet. Gezeigt wird ein Positionssensorsystems 1 mit je drei Erregungswicklungen 3a, 7, 3a, 7 und drei Sensorwicklungen 3b, 8, 3b, 8, wobei nur die äußeren Leiterbahnen 3a, 3b auf der äußeren Kupferschicht 3 der Oberseite der Mehrlagenleiterplatte 2 dargestellt sind.

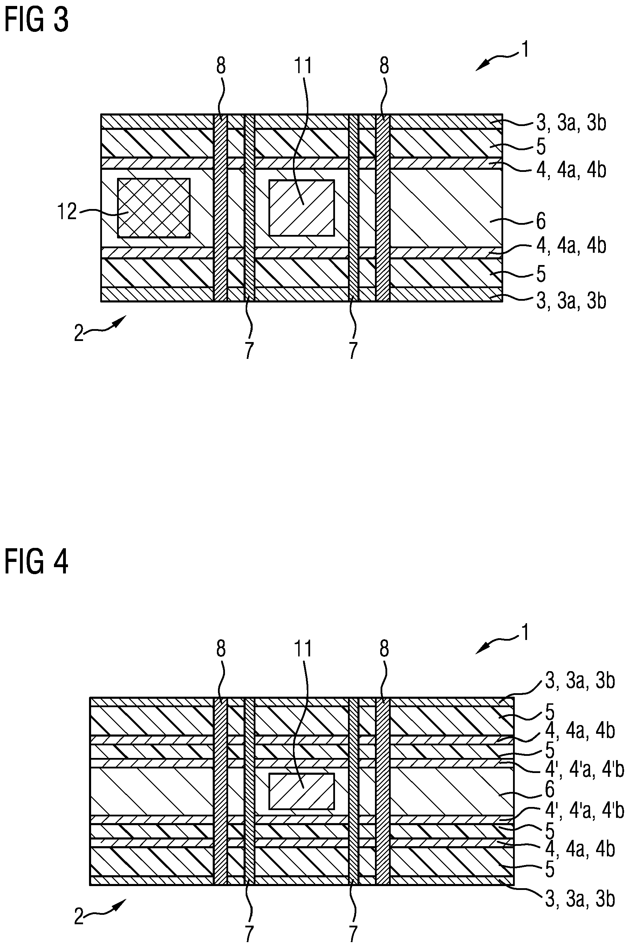

Fig. 3 zeigt eine schematische Darstellung eines Sensormoduls. Das Sensormodul umfasst ein Positionssensorsystem 1 gemäß Fig. 1 und eine insbesondere im Leiterplattenkern 6 der Mehrlagenleiterplatte 2 angeordnete entsprechende Auswerteelektronik 12, oder einem Teil davon, zur Verarbeitung der Signale aus dem Positionssensorsystem 1. Die Auswerteelektronik 12 kann auch auf oder außerhalb der Mehrlagenleiterplatte 2 angeordnet sein.

Ebenso kann das Sensormodul mehr als einen Sensor und/ oder mehr als eine Auswerteelektronik 12 umfassen.

Fig. 4 zeigt eine schematische Darstellung eines Positionssensorsystems 1 wie Fig. 1 nur mit zwei zusätzlichen Lagen, umfassend je eine weitere innere Kupferschicht 4' und eine weitere Isolatorschicht 5. Dabei umfasst eine innere Kupferschicht 4` insbesondere jeweils erste innere Leiterbahnen 4`a und zweite innere Leiterbahnen 4'b.

Die äußeren Leiterbahnen 3a, 3b und die inneren Leiterbahnen 4a, 4b, 4'a, 4'b werden insbesondere jeweils durch erste und zweite Durchkontaktierungen 7, 8, oder durch entsprechende Abschnitte davon, unter Ausbildung entsprechender Wicklungen, miteinander elektrisch verbunden.

Eine Erregerwicklung einer Erregungsspule beziehungsweise eine Sensorwicklung einer Sensorspule aus Leiterbahnen 3a, 3b, 4a, 4b, 4'a, 4'b und Durchkontaktierungen 7, 8, beziehungsweise entsprechenden Abschnitten der Durchkontaktierungen 7, 8, kann insbesondere in Bezug auf die Lagen der Mehrlagenleiterplatte 2 und/ oder in Bezug auf die Durchkontaktierungen 7, 8 symmetrisch oder asymmetrisch zum weichmagnetischen Kern 11 angeordnet sein.

Beispiele einer symmetrischen Anordnung einer Wicklung sind:
4'a,7,4'a, 7;
4'b, 8,4'b, 8;
4a, 7, 4a, 7;
4b, 8, 4b, 8;
3a, 7, 3a, 7;
3b, 8, 3b, 8;

Beispiele einer asymmetrischen Anordnung einer Wicklung in Bezug auf die Lage sind:
4'a, 7, 4a, 7;
3a, 7, 4'a, 7;

Beispiele einer asymmetrischen Anordnung einer Wicklung in Bezug auf die Durchkontaktierungen 7, 8 sind:
4'a, 7, 4b, 8;
3b, 8, 4'a, 7;
wobei bei den angegebenen Kombinationen die erst genannte Leiterbahn in Bezug auf den Kern 11 oberhalb und die an zweiter Stelle genannte Leiterbahn in Bezug auf den Kern 11 unterhalb des Kerns 11 angeordnet ist; und die zuerst genannte Durchkontaktierung in Bezug auf den Kern 11 links und die an zweiter Stelle genannte Durchkontaktierung in Bezug auf den Kern 11 rechts vom Kern 11 angeordnet ist.

Wie bereits erwähnt, sind an Wicklungen aus inneren Leiterbahnen die entsprechenden Durchkontaktierungen 7, 8 nur abschnittsweise beteiligt.

Wie ebenfalls bereits erwähnt, können Erregerspule und Sensorspule je nach Anwendungsfall auch vertauscht sein.

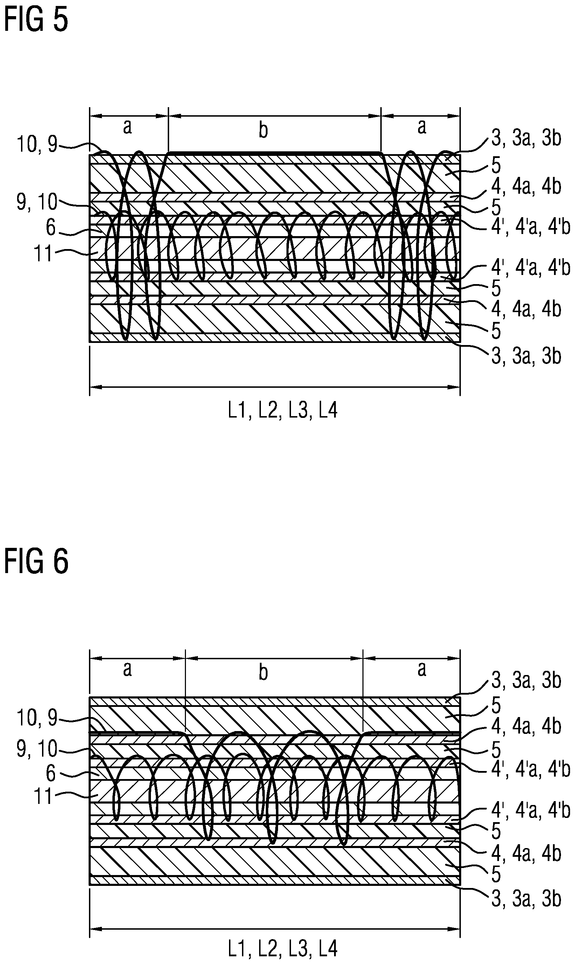

Nachfolgend zeigen Fig. 5 bis 7 schematische Darstellungen eines Positionssensorsystems gemäß Fig. 4 im Längsschnitt. Dabei sind die Erregerspule 9 und die Sensorspule 10 abweichend von den Darstellungen der Fig. 1 bis 4 zur besseren räumlichen Veranschaulichung als Spulen mit runden Wicklungen gezeigt.

Die Mehrlagenleiterplatte 2 weist eine Länge L1, die Erregungsspule 9 weist eine Länge L2, die Sensorspule 10 weist eine Länge L3 und der weichmagnetische Kern 11 weist eine Länge L4 auf. Die Längen L1, L2, L3 und L4 sind jeweils in äußere Abschnitte a und einen inneren Abschnitt b unterteilt.

Die Längen L2, L3 und L4 können innerhalb des Maximalwertes L1 der Mehrlagenleiterplatte 2 unterschiedliche Werte annehmen.

Die Wicklungen der Erregungsspule 9 und/ oder der Sensorspule 10 können über die entsprechende Länge L2, L3 gleichmäßig, insbesondere äquidistant verteilt sein.

Die Wicklungen der Erregungsspule 9 und/ oder der Sensorspule 10 können aber auch über die entsprechende Länge L2, L3 nicht gleichmäßig verteilt sein.

Dabei können die Wicklungen der Erregungsspule 9 und/ oder der Sensorspule 10 vorwiegend an einem äußeren Abschnitt a oder an einem inneren Abschnitt b angeordnet sein.

In Fig. 5, in Verbindung mit Fig. 2, wird eine Wicklung der Erregungsspule 9 durch zweite äußere Leiterbahnen 3b und zweite Durchkontaktierungen 8 gebildet, wobei die Wicklungen in den beiden äußeren Abschnitten a der Länge L2 der Erregungsspule 9 symmetrisch zum Kern 11 angeordnet sind.

Eine Wicklung der Sensorspule 10 wird durch zweite innere Leiterbahnen 4`a und entsprechende Abschnitte der ersten Durchkontaktierungen 7 gebildet, wobei die Wicklungen gleichmäßig über die gesamte Länge L3 der Sensorspule 10 verteilt symmetrisch zum Kern 11 angeordnet sind.

Hier schließt die Erregungsspule 9 die Sensorspule 10 ein. Erregungsspule 9 und Sensorspule 10 könnten auch vertauscht sein.

In Fig. 6, in Verbindung mit Fig. 2, wird wie in Fig. 5 eine Wicklung der Sensorspule 10 durch zweite innere Leiterbahnen 4`a und entsprechende Abschnitte der ersten Durchkontaktierungen 7 gebildet, wobei die Wicklungen gleichmäßig über die gesamte Länge L3 der Sensorspule 10 verteilt symmetrisch zum Kern 11 angeordnet sind.

Abweichend von Fig. 5 wird hier eine Wicklung der Erregungsspule 9 durch zweite äußere Leiterbahnen 4b auf der inneren Kupferschicht 4 und entsprechende Abschnitte der zweiten Durchkontaktierungen 8 gebildet, wobei die Wicklungen im inneren Abschnitt b der Länge L2 der Erregungsspule 9 symmetrisch zum Kern 11, insbesondere gleichmäßig verteilt angeordnet sind.

Auch hier schließt die Erregungsspule 9 die Sensorspule 10 ein. Erregungsspule 9 und Sensorspule 10 können auch vertauscht sein.

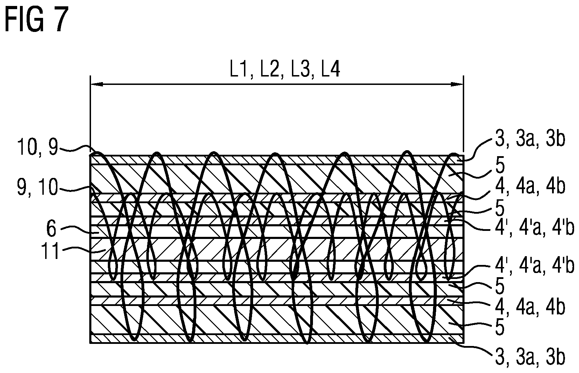

In Fig. 7, in Verbindung mit Fig. 2, wird eine Wicklung der Erregungsspule 9 durch zweite äußere Leiterbahnen 3b und zweite Durchkontaktierungen 8 gebildet, wobei die Wicklungen gleichmäßig über die gesamte Länge L2 der Erregungsspule 9 verteilt symmetrisch zum Kern 11 angeordnet sind.

Eine Wicklung der Sensorspule 10 wird durch eine erste innere Leiterbahn 4a, eine erste innere Leiterbahn 4`a und entsprechende Abschnitte der ersten Durchkontaktierungen 7 gebildet, wobei die Wicklungen gleichmäßig über die gesamte Länge L3 der Sensorspule 10 verteilt sind. Diese Ausführungsform stellt ein Beispiel für eine asymmetrische Anordnung einer Wicklung in Bezug auf die Lage der Mehrlagenleiterplatte 2 dar.

Auch hier schließt die Erregungsspule 9 die Sensorspule 10 einschließt. Erregungsspule 9 und Sensorspule 10 können auch je nach Anwendungsfall vertauscht sein.

Es wäre auch denkbar, dass ein Wechsel einer Lage der Mehrlagenleiterplatte 2 von Wicklung zu Wicklung stattfindet.

### Bezugszeichenliste:

- 1: Sensorsystem
- 2: Mehrlagenleiterplatte
- 3: Äußere Kupferschicht
- 3a: Erste äußere Leiterbahn
- 3b: Zweite äußere Leiterbahn
- 4: Innere Kupferschicht
- 4a: Erste innere Leiterbahn auf 4
- 4b: Zweite innere Leiterbahn auf 4
- 4': Innere Kupferschicht
- 4'a: Erste innere Leiterbahn auf 4'
- 4'b: Zweite innere Leiterbahn auf 4`
- 5: Isolatorschicht, Prepregschicht
- 6: Leiterplattenkern
- 7: Erste Durchkontaktierung
- 8: Zweite Durchkontaktierung
- 9: Erregungsspule
- 10: Sensorspule
- 11: Weichmagnetischer Kern
- 12: Auswerteelektronik
- L1: Länge der Mehrlagenleiterplatte
- L2: Länge der Erregungsspule
- L3: Länge der Sensorspule
- L4: Länge des Kerns
- a: Äußerer Abschnitt
- b: Innerer Abschnitt

## Patentansprüche

1. Magnetisches Positionssensorsystem (1) umfassend,
- eine Mehrlagenleiterplatte (2)
- wobei eine Lage eine Isolatorschicht (5) und mindestens eine Kupferschicht (3, 4, 4') umfasst,
- eine Kupferschicht (3, 4, 4') mindestens eine erste Leiterbahn (3a, 4a, 4'a) und/ oder eine zweite Leiterbahn (3b, 4b, 4'b) umfasst,
- erste Durchkontaktierungen (7), zweite Durchkontaktierungen (8) und einen Leiterplattenkern (6), und
- einen Sensor mit einem weichmagnetischen Kern (11), einer Erregungsspule mit wenigstens einer Erregungswicklung und einer Sensorspule mit wenigstens einer Sensorwicklung,
**dadurch gekennzeichnet, dass**
der weichmagnetische Kern (11) gänzlich im Leiterplattenkern (6) der Mehrlagenleiterplatte (2) angeordnet ist, und von einer Erregungsspule und einer Sensorspule umgeben ist, wobei eine Erregungswicklung der Erregungsspule je zwei erste Durchkontaktierungen (7) wenigstens abschnittsweise und zwei erste Leiterbahnen (3a, 4a, 4`a) umfasst, und wobei eine Sensorwicklung der Sensorspule je zwei zweite Durchkontaktierungen (8) wenigstens abschnittsweise und zwei zweite Leiterbahnen (3b, 4b, 4'b) umfasst, wobei der weichmagnetische Kern (11) von der Erregungsspule mit mindestens einer Erregungswicklung und der Sensorspule mit mindestens einer Sensorwicklung im Wesentlichen konzentrisch umgeben ist.

2. Magnetisches Positionssensorsystem (1) nach Anspruch 1, **dadurch gekennzeichnet, dass** die Erregungsspule und die Sensorspule auf unterschiedlichen Lagen der Mehrlagenleiterplatte (2) angeordnet sind.

3. Magnetisches Positionssensorsystem (1) nach Anspruch 1, **dadurch gekennzeichnet, dass** die Erregungsspule und die Sensorspule auf derselben Lage der Mehrlagenleiterplatte (2) angeordnet sind.

4. Magnetisches Positionssensorsystem (1) nach Anspruch 3, **dadurch gekennzeichnet, dass** eine Erregungswicklung je zwei erste Durchkontaktierungen (7) und zwei erste Leiterbahnen (3a) auf der äußeren Kupferschicht (3) umfasst, und wobei eine Sensorwicklung je zwei zweite Durchkontaktierungen (8) und zwei zweite Leiterbahnen (3b) auf der äußeren Kupferschicht (3) umfasst.

5. Magnetisches Positionssensorsystem (1) nach einem der vorhergehenden Ansprüche, **dadurch gekennzeichnet, dass** die Mehragenleiterplatte (2) eine Länge (L1), die Erregungsspule eine Länge (L2), die Sensorspule eine Länge (L3) und der Kern (11) eine Länge (L4) aufweist, wobei die Längen (L1, L2, L3 und L4) jeweils in äußere Abschnitte (a) und innere Abschnitte (b) unterteilt sind.

6. Magnetisches Positionssensorsystem (1) nach einem der vorhergehenden Ansprüche, **dadurch gekennzeichnet, dass** die Wicklungen der Erregungsspule und/ oder der Sensorspule gleichmäßig über die entsprechende Länge (L2, L3) verteilt sind.

7. Magnetisches Positionssensorsystem (1) nach einem der Ansprüche 1 bis 5, **dadurch gekennzeichnet, dass** die Wicklungen der Erregungsspule und/ oder der Sensorspule nicht gleichmäßig über die entsprechende Länge (L2, L3) verteilt sind.

8. Magnetisches Positionssensorsystem (1) nach Anspruch 7, **dadurch gekennzeichnet, dass** die Wicklungen der Erregungsspule und/ oder der Sensorspule vorwiegend an einem äußeren Abschnitt (a) angeordnet sind.

9. Magnetisches Positionssensorsystem (1) nach Anspruch 7, **dadurch gekennzeichnet, dass** die Wicklungen der Erregungsspule und/ oder der Sensorspule vorwiegend an einem inneren Abschnitt (b) angeordnet sind.

10. Magnetisches Positionssensorsystem (1) nach einem der vorhergehenden Ansprüche, **dadurch gekennzeichnet, dass** die Erregungsspule die Sensorspule abschnittsweise oder ganz einschließt.

11. Magnetisches Positionssensorsystem (1) nach einem der Ansprüche 1 bis 9, **dadurch gekennzeichnet, dass** die Sensorspule die Erregungsspule abschnittsweise oder ganz einschließt.

12. Magnetisches Positionssensorsystem (1) nach einem der vorhergehenden Ansprüche, **dadurch gekennzeichnet, dass** die Wicklungen der Erregungsspule und/ oder der Sensorspule symmetrisch zum Kern (11) angeordnet sind.

13. Magnetisches Positionssensorsystem (1) nach einem der Ansprüche 1 bis 11, **dadurch gekennzeichnet, dass** die Wicklungen der Erregungsspule und/ oder der Sensorspule asymmetrisch zum Kern (11) angeordnet sind.

14. Positionssensorsystem (1) nach einem der vorhergehenden Ansprüche, **dadurch gekennzeichnet, dass** der Kern (11) streifenförmig ausgebildet ist.

15. Sensormodul, **dadurch gekennzeichnet, dass** das Sensormodul wenigstens ein Positionssensorsystem (1) nach einem der vorhergehenden Ansprüche und zumindest Teile einer Auswerteelektronik (12) umfasst.

16. Sensormodul nach Anspruch 15, **dadurch gekennzeichnet, dass** die Auswerteelektronik (12) zumindest teilweise in, auf oder außerhalb der Mehrlagenleiterplatte (2) angeordnet ist.

17. Steuergerät, **dadurch gekennzeichnet, dass** das Steuergerät ein Sensormodul nach einem der Ansprüche 15 oder 16 umfasst.

## Claims

1. Magnetic position sensor system (1) comprising
- a multilayer circuit board (2)
- wherein a layer comprises an insulator layer (5) and at least one copper layer (3, 4, 4'),
- a copper layer (3, 4, 4') comprises at least a first conductor track (3a, 4a, 4'a) and/or a second conductor track (3b, 4b, 4'b),
- first vias (7), second vias (8) and a circuit board core (6), and
- a sensor with a soft magnetic core (11), an excitation coil with at least one excitation winding and a sensor coil with at least one sensor winding,
**characterized in that**
the soft magnetic core (11) is arranged entirely in the circuit board core (6) of the multilayer circuit board (2), and is surrounded by an excitation coil and a sensor coil, wherein an excitation winding of the excitation coil comprises two first vias (7), at least in sections, and two first conductor tracks (3a, 4a, 4'a), and wherein a sensor winding of the sensor coil comprises two second vias (8), at least in sections, and two second conductor tracks (3b, 4b, 4'b), wherein the soft magnetic core (11) is essentially concentrically surrounded by the excitation coil with at least one excitation winding and the sensor coil with at least one sensor winding.

2. Magnetic position sensor system (1) according to Claim 1, **characterized in that** the excitation coil and the sensor coil are arranged on different layers of the multilayer circuit board (2).

3. Magnetic position sensor system (1) according to Claim 1, **characterized in that** the excitation coil and the sensor coil are arranged on the same layer of the multilayer circuit board (2).

4. Magnetic position sensor system (1) according to Claim 3, **characterized in that** an excitation winding comprises two first vias (7) and two first conductor tracks (3a) on the outer copper layer (3), and wherein a sensor winding comprises two second vias (8) and two second conductor tracks (3b) on the outer copper layer (3) .

5. Magnetic position sensor system (1) according to one of the preceding claims, **characterized in that** the multilayer circuit board (2) has a length (L1), the excitation coil has a length (L2), the sensor coil has a length (L3) and the core (11) has a length (L4), wherein the lengths (L1, L2, L3 and L4) are respectively divided into outer sections (a) and inner sections (b).

6. Magnetic position sensor system (1) according to one of the preceding claims, **characterized in that** the windings of the excitation coil and/or of the sensor coil are distributed uniformly over the corresponding length (L2, L3).

7. Magnetic position sensor system (1) according to one of Claims 1 to 5, **characterized in that** the windings of the excitation coil and/or of the sensor coil are distributed non-uniformly over the corresponding length (L2, L3).

8. Magnetic position sensor system (1) according to Claim 7, **characterized in that** the windings of the excitation coil and/or of the sensor coil are arranged predominantly on an outer section (a).

9. Magnetic position sensor system (1) according to Claim 7, **characterized in that** the windings of the excitation coil and/or of the sensor coil are arranged predominantly on an inner section (b).

10. Magnetic position sensor system (1) according to one of the preceding claims, **characterized in that** the excitation coil encloses the sensor coil in sections or entirely.

11. Magnetic position sensor system (1) according to one of Claims 1 to 9, **characterized in that** the sensor coil encloses the excitation coil in sections or entirely.

12. Magnetic position sensor system (1) according to one of the preceding claims, **characterized in that** the windings of the excitation coil and/or of the sensor coil are arranged symmetrically in relation to the core (11).

13. Magnetic position sensor system (1) according to one of Claims 1 to 11, **characterized in that** the windings of the excitation coil and/or of the sensor coil are arranged asymmetrically in relation to the core (11).

14. Position sensor system (1) according to one of the preceding claims, **characterized in that** the core (11) is of a strip-shaped form.

15. Sensor module, **characterized in that** the sensor module comprises at least one position sensor system (1) according to one of the preceding claims and at least parts of an electronic evaluating unit (12).

16. Sensor module according to Claim 15, **characterized in that** the electronic evaluating unit (12) is arranged at least partially in, on or outside the multilayer circuit board (2).

17. Control device, **characterized in that** the control device comprises a sensor module according to either of Claims 15 and 16.

## Revendications

1. Système de capteur de position magnétique (1) comprenant,
- un circuit imprimé multicouche (2)
- une couche comprenant une couche isolante (5) et au moins une couche de cuivre (3, 4, 4'),
- une couche de cuivre (3, 4, 4') comprend au moins une première piste conductrice (3a, 4a, 4'a) et/ou une deuxième piste conductrice (3b, 4b, 4'b),
- des premiers trous d'interconnexion (7), des deuxièmes trous d'interconnexion (8) et un noyau de carte de circuit imprimé (6), et
- un capteur comprenant un noyau magnétique doux (11), une bobine d'excitation comprenant au moins un enroulement d'excitation et une bobine de capteur comprenant au moins un enroulement de capteur,
**caractérisé en ce que**
le noyau magnétique doux (11) est disposé entièrement dans le noyau de carte de circuit imprimé (6) du circuit imprimé multicouche (2) et il est entouré d'une bobine d'excitation et d'une bobine de capteur, un enroulement d'excitation de la bobine d'excitation comprenant respectivement deux premiers trous d'interconnexion (7) au moins dans certaines portions et deux premières pistes conductrices (3a, 4a, 4'a), et un enroulement de capteur de la bobine de capteur comprenant respectivement deux deuxièmes trous d'interconnexion (8) au moins dans certaines portions et deux deuxièmes pistes conductrices (3b, 4b, 4'b), le noyau magnétique doux (11) étant entouré de manière sensiblement concentrique par la bobine d'excitation avec au moins un enroulement d'excitation et par la bobine de capteur avec au moins un enroulement de capteur.

2. Système de capteur de position magnétique (1) selon la revendication 1, **caractérisé en ce que** la bobine d'excitation et la bobine de capteur sont disposées sur des couches différentes du circuit imprimé multicouche (2) .

3. Système de capteur de position magnétique (1) selon la revendication 1, **caractérisé en ce que** la bobine d'excitation et la bobine de capteur sont disposées sur la même couche du circuit imprimé multicouche (2).

4. Système de capteur de position magnétique (1) selon la revendication 3, **caractérisé en ce qu'**un enroulement d'excitation comprend respectivement deux premiers trous d'interconnexion (7) et deux premières pistes conductrices (3a) sur la couche de cuivre extérieure (3), et un enroulement de capteur comprenant respectivement deux deuxièmes trous d'interconnexion (8) et deux deuxièmes pistes conductrices (3b) sur la couche de cuivre extérieure (3).

5. Système de capteur de position magnétique (1) selon l'une des revendications précédentes, **caractérisé en ce que** le circuit imprimé multicouche (2) présente une longueur (L1), la bobine d'excitation une longueur (L2), la bobine de capteur une longueur (L3) et le noyau (11) une longueur (L4), les longueurs (L1, L2, L3 et L4) étant respectivement subdivisées en sections externes (a) et en sections internes (b).

6. Système de capteur de position magnétique (1) selon l'une des revendications précédentes, **caractérisé en ce que** les enroulements de la bobine d'excitation et/ou de la bobine de détection sont répartis uniformément sur la longueur correspondante (L2, L3).

7. Système de capteur de position magnétique (1) selon l'une des revendications 1 à 5, **caractérisé en ce que** les enroulements de la bobine d'excitation et/ou de la bobine de détection ne sont pas uniformément répartis sur la longueur correspondante (L2, L3).

8. Système de capteur de position magnétique (1) selon la revendication 7, **caractérisé en ce que** les enroulements de la bobine d'excitation et/ou de la bobine de capteur sont disposés principalement sur une portion extérieure (a).

9. Système de capteur de position magnétique (1) selon la revendication 7, **caractérisé en ce que** les enroulements de la bobine d'excitation et/ou de la bobine de capteur sont disposés principalement sur une portion intérieure (b).

10. Système de capteur de position magnétique (1) selon l'une des revendications précédentes, **caractérisé en ce que** la bobine d'excitation englobe partiellement ou totalement la bobine de capteur.

11. Système de capteur de position magnétique (1) selon l'une des revendications 1 à 9, **caractérisé en ce que** la bobine de capteur englobe partiellement ou totalement la bobine d'excitation.

12. Système de capteur de position magnétique (1) selon l'une des revendications précédentes, **caractérisé en ce que** les enroulements de la bobine d'excitation et/ou de la bobine de détection sont disposés de manière symétrique par rapport au noyau (11).

13. Système de capteur de position magnétique (1) selon l'une des revendications 1 à 11, **caractérisé en ce que** les enroulements de la bobine d'excitation et/ou de la bobine de détection sont disposés de manière asymétrique par rapport au noyau (11).

14. Système de capteur de position (1) selon l'une des revendications précédentes, **caractérisé en ce que** le noyau (11) est configuré en forme de bande.

15. Module de capteur, **caractérisé en ce que** le module de capteur comprend au moins un système de capteur de position (1) selon l'une des revendications précédentes et au moins des parties d'une électronique d'interprétation (12).

16. Module de capteur selon la revendication 15, **caractérisé en ce que** l'électronique d'interprétation (12) est disposée au moins partiellement dans, sur ou à l'extérieur du circuit imprimé multicouche (2).

17. Contrôleur, **caractérisé en ce que** le contrôleur comprend un module de capteurs selon l'une des revendications 15 ou 16.
